(19) Europäisches Patentamt
European Patent Office
Office européen des brevets

(11) Veröffentlichungsnummer: **0 109 630 B1**

(12) **EUROPÄISCHE PATENTSCHRIFT**

(45) Veröffentlichungstag der Patentschrift: **14.08.91**

(51) Int. Cl.5: **G03F 7/021**

(21) Anmeldenummer: **83111330.3**

(22) Anmeldetag: **12.11.83**


# (54) Verfahren zur Herstellung von Druckplatten.


(30) Priorität: **19.11.82 US 443079**

(43) Veröffentlichungstag der Anmeldung:
**30.05.84 Patentblatt 84/22**

(45) Bekanntmachung des Hinweises auf die Patenterteilung:
**14.08.91 Patentblatt 91/33**

(84) Benannte Vertragsstaaten:
**DE FR GB NL**

(56) Entgegenhaltungen:
**DE-C- 857 888**
**DE-C- 876 951**
**GB-A- 2 087 580**
**US-A- 3 149 972**
**US-A- 3 373 021**
**US-A- 4 446 218**



(73) Patentinhaber: **HOECHST CELANESE CORPORATION**
**Route 202-206 North**
**Somerville, N.J. 08876(US)**

(72) Erfinder: **Mohr, Dieter, Dr.**
**Breitenweg 36**
**W-6725 Römerberg 2(DE)**

(74) Vertreter: **Euler, Kurt Emil, Dr. et al**
**KALLE Niederlassung der Hoechst AG**
**Rheingaustrasse 190 Postfach 3540**
**W-6200 Wiesbaden 1(DE)**



EP 0 109 630 B1



Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung betrifft ein Verfahren für die Herstellung von Druckplatten, insbesondere Flaohdruckplatten.

Bei der Belichtung von lichtempfindlichen Druckplatten auf Basis von negativ arbeitenden Diazoniumverbindungen besteht das Problem, daß nach dem Belichten noch ein gewisser Anteil an unzersetzter Diazoniumverbindung in den Bildstellen vorhanden ist. Die unzersetzte Diazoniumverbindung neigt dazu, mit bestimmten Bestandteilen des Entwicklers, der Schlußbehandlungslösung oder des Feuchtwassers zu reagieren, und eine solche Reaktion kann hydrophile Stellen auf der Schichtoberfläche hervorrufen und zu einer verminderten Farbannahme an diesen Stellen führen. Dieser Zustand äußert sich in Gestalt von langsamem Freilaufen, Blindlaufen und vermindertem Kontrast, der sich durch eine große Zahl von teilweise gedeckten Stufen auf dem Stufenkeil anzeigt.

Es ist bekannt, Diazoverbindungen unter bestimmten Bedingungen mit phenolischen Kupplern zu nicht lichtempfindlichen Azofarbstoffen umzusetzen. Die EP-A 0024 872 beschreibt ein Verfahren zur Herstellung von Flachdruckplatten, bei dem die Platte nach dem Entfernen der Nichtbildstellen durch Entwickeln mit einer Schlußbehandlungslösung behandelt wird, um die noch unzersetzte Diazoniumverbindung aus diesen Bereichen zu beseitigen.

Dieses Verfahren hat jedoch den Nachteil, daß die unzersetzte Diazoniumverbindung nur an der Oberfläche der Bildstellen umgesetzt wird. Die mit der Diazoniumverbindung reagierenden Verbindungen können nicht wesentlich in die Beschichtung eindringen. Wenn also während des Auflagendrucks ein bestimmter Abnutzungsgrad der Beschichtung erreicht ist, befindet sich erneut unzersetzte Diazoniumverbindung an der Oberfläche der Bildstellen, die mit hydrophilen Bestandteilen des Feuchtwassers oder der während der Stillstandzeiten der Druckmaschine verwendeten Reinigungslösungen reagieren können.

Die US-A 3 300 309 und 4 171 974 beschreiben die Herstellung von lichtempfindlichen Reaktionsprodukten aus Diazoniumsalzen und sogenannten Kupplungsmitteln. Dabei handelt es sich jedoch nicht um Azokupplungsreaktionen. Die in diesen Veröffentlichungen beschriebenen Reaktionen sind Ionenreaktionen, bei denen das Anion eines wasserlöslichen Diazoniumsalzes durch eine aromatische, Hydroxygruppen enthaltende Verbindung ersetzt wird, so daß die neue Verbindung zwar lichtempfindlich bleibt, jedoch wasserunlöslich wird. Im Gegensatz dazu wird bei echten Azokupplungsreaktionen durch Umsetzen der Diazoniumgruppe eine nicht lichtempfindliche Azoverbindung gebildet.

In der älteren deutschen Patentanmeldung 33 07 037 wird ein lichtempfindliches Material für die Herstellung von Farbprüffolien und anderen nicht zum Druck bestimmten reprographischen Materialien beschrieben, dessen lichtempfindliche Schicht ein Diazoniumsalz-Polykondensationsprodukt und bestimmte kupplungsfähige Phenole zur Erhöhung der Lichtempfindlichkeit enthält.

In der US-A-3 373 021 wird ein Verfahren zur Herstellung einer positivarbeitenden Druckplatte beschrieben, bei dem eine Schicht aus einer wasserunlöslichen Diazoverbindung bildmäßig belichtet und dadurch hydrophiliert, an den unbelichteten Stellen dagegen durch Azokupplung oleophil gemacht wird.

Aufgabe der vorliegenden Erfindung war es, ein Verfahren für die Herstellung von Druckplatten bereitzustellen, das sich durch rasche Farbannahme der Bildstellen, steile Gradation und hohe Lichtempfindlichkeit auszeichnet.

Für das erfindungsgemäße Verfahren wird ein lichtempfindliches Material für die Herstellung von Druckplatten mit einem metallischen Schichtträger und einer sauren lichthärtbaren Schicht vorgeschlagen, die ein Diazoniumsalz-Polykondensationsprodukt und eine phenolische Verbindung der allgemeinen Formel I

$$[Ar(OH)_m(Z)_o(COX)_n]_pY \quad (I)$$

enthält, worin

| | |
|---|---|
| Ar | ein ein- oder zweikerniger aromatischer Rest, |
| Z | ein Halogenatom oder eine niedere Alkylgruppe, |
| X | ein Halogenatom, eine Hydroxygruppe oder der Rest $NR^1R^2$, |
| Y | eine Einfachbindung oder ein Bindeglied der Formel -O-, -S-, -CO-, $-C_dH_{2d}-$ ist, |
| $R^1$ und $R^2$ | gleich oder verschieden sind und Wasserstoffatome, niedere Alkylgruppen oder Hydroxyalkylgruppen bedeuten, |
| m | eine ganze Zahl von 1 bis 3, |
| n | 1 oder 2, |
| o | 0 oder 1, |
| p | 1 oder 2 und |

d eine ganze Zahl von 1 bis 8 ist.

Die Diazoniumverbindung und die phenolische Verbindung liegen in der lichtempfindlichen Schicht nebeneinander in nicht umgesetztem Zustand vor. Dies wird dadurch bewirkt, daß die Schicht sauer ist. Gegebenenfalls kann die Lagerfähigkeit durch Zusatz von Säure erhöht werden.

Die bildmäßig belichtete Schicht wird mit einem neutralen oder vorzugsweise alkalischen Entwickler so entwickelt, daß die unbelichteten Nichtbildstellen entfernt werden, bevor es dort zur Kupplungsreaktion kommt. Das ist erforderlich, weil die unbelichteten Bereiche fast ausschließlich aus Diazoniumverbindung bestehen und in dem durch den Entwickler erzeugten alkalischen Medium kuppeln würden. Der Entwickler bewirkt jedoch eine Kupplung der in den Bildstellen zurückbleibenden Reste von unzersetzter Diazoniumverbindung.

Durch den Zusatz von Kupplern zur Beschichtung kann die unzersetzte Diazoniumverbindung in der Beschichtungsmasse im wesentlichen zum Azofarbstoff umgesetzt werden, da die Hydroxylionen, welche die Kupplungsreaktion beschleunigen, sehr wohl bis auf den Grund der Beschichtung vordringen können.

Das bei dem erfindungsgemäßen Verfahren verwendete Material hat eine verbesserte Lichtempfindlichkeit und erhöhte Entwicklungsgeschwindigkeit. Ferner ist die Auflösewirkung des alkalischen Entwicklers in den unbelichteten Nichtbildstellen rascher als seine die Kupplungsreaktion auslösende Wirkung. In fast völlig ausbelichteten Bereichen mit verminderter Löslichkeit im Entwickler herrscht dagegen die Kupplungsreaktion gegenüber der Auflösung vor. Auf diese Weise werden durch die Reaktion mischen Diazoniumverbindung und Kuppler auf chemischem Wege zusätzliche vollgedeckte Stufen gebildet, so daß die praktische Lichtempfindlichkeit wirkungsvoll erhöht wird. Die nach dem Belichten in den Bildstellen verbliebene unzersetzte Diazoverbindung wird durch Umwandlung in einen Azofarbstoff inaktiviert. Eine derartige hochlichtempfindliche Beschichtung ist für Laserbebilderungssysteme geeignet.

Für diese Erfindung geeignete negativ arbeitende Diazoniumverbindungen haben die allgemeine Formel $ArN_2X$, worin Ar einen aromatischen Rest und X ein saures Anion bezeichnen. Diese Verbindungen können durch Wasserstoff, Halogen, Alkyl-, Carboxy-, Alkoxy-, Acetoxy-, Carbamyl-, Nitro-, Phenyl- oder Aminogruppen am aromatischen Kern einfach oder mehrfach substituiert sein. Typische Diazoniumverbindungen sind zum Beispiel auf den Seiten 194-214 und 321-330 in "Light-Sensitive Systems" von Jaromir Kosar (John Wiley & Sons, Inc., New York, 1965) aufgeführt.

Beispiele für Verbindungen der oben genannten allgemeinen Formel I sind:

3,5-Resorcylsäure
2,4-Resorcylsäure
2,6-Resorcylsäure
4-Brom-3,5-resorcylsäure
2,3-Dihydroxy-1-naphthoesäure
3,5-Resorcylsäure-ethanolamid
3,5-Resorcylsäurechlorid
3,5-Resorcylsäure-diethanolamid
2,4-Resorcylsäure-ethanolamid
2,4-Resorcylsäureamid
4-Brom-3,5-resorcylsäureamid
2-Hydroxy-4-methyl-benzoesäure
Salicylsäure
2,4,7-Trihydroxy-naphthalin-1-carbonsäure
2,4-Dihydroxy-naphthalin-dicarbonsäure
3,5,3',5'-Tetrahydroxy-diphenyl-2,2'-dicarbonsäure
3,5,3',5'-Tetrahydroxy-diphenylsulfid-4,4'-dicarbonsäure

Diese Verbindungen werden der Beschichtungslösung in einer Menge von 5 bis 40 %, vorzugsweise von 7,5 bis 25 % und insbesondere von 10 bis 20 %, jeweils bezogen auf die Menge an Diazoniumverbindung, zugesetzt.

Die Lösung kann gegebenenfalls weitere verträgliche Restandteile, zum Beispiel Lösemittel, Säuren, Farbstoffe, Harze und andere übliche Zusätze, enthalten.

Das saure Medium kann durch Zugabe bestimmter verträglicher Säuren zu der Lösung hergestellt werden. Diese Säuren können sowohl Mineralsäuren als auch organische Säuren sein. Beispiele für solche Säuren sind Sulfonsäuren, Phosphonsäuren, Phosphorsäure, Schwefelsäure, Essigsäure, Zitronensäure, Oxalsäure und p-Toluolsulfonsäure. Die Säuren sind vorzugsweise in einem Anteil von etwa 0,1 bis 20 %, bezogen auf das Gewicht der Diazoniumverbindung, in der Beschichtungslösung enthalten. Der Säureanteil liegt insbesondere im Bereich von 1 bis 10 %.

Bei der Herstellung der für das erfindungsgemäße Verfahren geeigneten photographischen Materialien wird die lichtempfindliche Lösung auf einen geeigneten Träger aufgebracht und getrocknet. Geeignete Trägermaterialien sind zum Beispiel Aluminiumlegierungen, Kupfer, Stahl, Chrom und Silicium. Besonders bevorzugt wird als Trägermaterial eine Aluminiumlegierung in Flachdruckqualität verwendet, die gegebenenfalls den üblichen Oberflächenbehandlungen unterzogen worden ist. Dabei kann zum Beispiel eine Trägerplatte, vorzugsweise aus Aluminium bzw. einer Aluminiumlegierung, insbesondere aus einer für die Herstellung von Flachdruckplatten geeigneten Aluminiumlegierung, z. B. Alcoa 3003 oder Alcoa 1100, die gegebenenfalls nach den bekannten Aufrauh- und/oder Ätzverfahren vorbehandelt wurde, durch Sprühen, Auftragen mit dem Pinsel, Tauchen oder nach anderen Verfahren mit einer Lösung beschichtet werden, die sich zur Bildung einer hydrophilierenden Zwischenschicht für Flachdruckplatten eignet. Zu den Standardvorbehandlungen für Metallträger zählen z. B. das chemische Ätzen, das chemische oder mechanische Aufrauhen und das Anodisieren nach bekannten Verfahren. Bei der praktischen Durchführung der Erfindung können als Vorbehandlungslösungen wäßrige Lösungen von hydrophilierenden Verbindungen eingesetzt werden, zum Beispiel von Alkalisilikat, Kieselsäure, Metallfluoriden der vierten Nebengruppe, Alkalisalzen, Polyvinylphosphonsäure, Polyacrylsäure, Alkalihexafluorozirkonaten, z. B. Kaliumhexafluorozirkonat, oder Hexafluorozirkonsäure, in Konzentrationen von 0,5 bis 20 Vol.-%. Die Konzentration der Lösung liegt vorzugsweise im Bereich von 3 bis 8 Vol.-%, insbesondere im Bereich von 4 bis 5 Vol.-%.

Als anodische Oxydationsbehandlung kann eine elektrolytische Behandlung des Trägers in einer wäßrigen Lösung von Schwefel-, Chrom- oder Phosphorsäure in einer Konzentration von etwa 0,5 bis 25 Gew.-% durchgeführt werden. Das Anodisierungsbad wird vorzugsweise auf einer Temperatur von etwa 15 bis 35 °C gehalten, und die Behandlung dauert etwa 1 bis 20 Minuten bei etwa 5 bis 20 V und einer Stromdichte von etwa 1 bis 8 $A/dm^2$.

Anschließend kann die lichtempfindliche Lösung auf den Träger aufgetragen und getrocknet werden. Das so hergestellte lichtempfindliche Material ist dann zum Belichten durch eine Vorlage mit UV- oder aktinischer Strahlung und zum Entwickeln bereit.

Es werden alkalische Entwicklerlösungen mit einem pH-Wert im Bereich von etwa 7,5 bis 12 verwendet. Bevorzugt beträgt der pH-Wert etwa 9 bis 11. Als Entwickler dienen vorzugsweise wäßrige Phosphat- und/oder Silikatlösungen, beispielsweise von Mono-, Di- und Trialkaliphosphat, Natriumsilikat und Alkalimetasilikat. Es können auch Alkalihydroxide verwendet werden; diese werden jedoch nicht bevorzugt. Die Entwickler können ferner noch übliche Tenside, Puffer und andere Bestandteile enthalten.

Die Erfindung wird anhand der folgenden Beispiele näher erläutert:

Vergleichsbeispiel 1

Eine 0,15 mm dicke walzblanke Aluminiumfolie wird bei 80 °C für die Dauer von 10 s in einer wäßrigen NaOH-Lösung entfettet. Anschließend wird sie in einer wäßrigen Lösung von $Al(NO_3)_3 \cdot 9\,H_2O$ und $HNO_3$ mit Wechselstrom einer Stromdichte von 45 $A/dm^2$ bis zu einer Rauhtiefe von 3,5 $\mu m$ elektrochemisch aufgerauht. Nach der Aufrauhbehandlung folgt eine anodische Oxydation in einem $H_2SO_4/Al_2(SO_4)_3$-Elektrolyten. Der Träger wird abschließend in einer wäßrigen Lösung von Polyvinylphosphonsäure nachbehandelt.

Zur Herstellung einer vorsensibilisierten Flachdruckplatte wird der Träger mit einer Lösung der folgenden Zusammensetzung beschichtet:

4,6 % eines Polykondensationsproduktes aus 1 Mol 3-Methoxydiphenylamin-4-diazoniumsulfat und 1 Mol 4,4'-Bis-methoxymethyl-diphenylether, ausgefällt als Mesitylensulfonat,
0,1 % $H_3PO_4$ (85 %-ig),
0,3 % Viktoriareinblau FGA (C.I. Basic Blue 81),
95 % Ethylenglykolmonomethylether.

Das Beschichtungsgewicht wird auf 800 $mg/m^2$ eingestellt.

Die so hergestellte Druckplatte wird unter einer Negativvorlage mit UV-Licht belichtet und zeigt nach dem Belichten ein sichtbares Bild. Der Entwicklungsvorgang in einer wäßrigen Lösung (pH-Wert 11) mit einem Gehalt an:

5 % Natriumdecylsulfat,
1 % Natriummetasilikat-pentahydrat ($Na_3SiO_3 \cdot 5H_2O$),
1,5 % Trinatriumphosphat-Dodecahydrat ($Na_3PO_4 \cdot 12H_2O$)

läuft langsam ab, ist jedoch annehmbar.

Beim Belichten der Platte mit 35 Belichtungseinheiten (1 Einheit ≙ 10 $mJ/cm^2$) durch einen 21-stufigen Stauffer-Stufenkeil ist nach dem Entwickeln mit der oben genannten Lösung die Stufe 6 voll gedeckt und die Stufe 13 teilweise gedeckt.

Beim Drucken mit der Platte wird eine Auflage von 70.000 erreicht.

Beispiel 1

Ein Aluminiumträger entsprechend Vergleichsbeispiel 1 wird mit einer Lösung der folgenden Zusammensetzung beschichtet:

| | |
|---|---|
| 4,6 % | der in Vergleichsbeispiel 1 genannten Diazoniumverbindung, |
| 0,1 % | $H_3PO_4$ (85 %ig), |
| 0,3 % | Viktoriareinblau FGA, |
| 0,92 % | 3,5-Resorcylsäure-ethanolamid, |
| 94,08 % | Ethylenglykolmonomethylether. |

Das Beschichtungsgewicht beträgt 800 mg/m$^2$.

Wenn diese Platte ebenso belichtet und verarbeitet wird wie eine gemäß Vergleichsbeispiel 1 hergestellte Platte, so zeigen sich die folgenden Vorteile:
Verbesserter Kontrast nach dem Belichten,
raschere Entwicklung,
erhöhte Lichtempfindlichkeit (Stufe 9 voll gedeckt),
weniger teilgedeckte Stufen (bis Stufe 13),
rascheres Freilaufen auf der Druckmaschine,
höhere Druckauflage (100.000 Drucke) und
verbesserte Lagerfähigkeit.

Bei Verwendung eines wäßrigen Entwicklers mit einem pH-Wert von etwa 8 ist die Wirkung des zugesetzten Kupplungsmittels auf die Lichtempfindlichkeit etwas geringer (Stufe 7 gedeckt, Stufe 11 teilweise gedeckt), da hierbei die Kupplungsreaktion während des Entwickelns langsamer abläuft.

Beispiele 2 bis 19

In der folgenden Tabelle sind die mit verschiedenen nach der Erfindung hergestellten Platten erzielten Ergebnisse aufgeführt, im Vergleich zu Platten, die mit der Beschichtungsrezeptur gemäß Vergleichsbeispiel 1 versehen sind. Für die Probenherstellung werden der Träger und die Grundrezeptur der Beschichtungslösung nach Vergleichsbeispiel 1 verwendet. Dieser Beschichtungslösung werden, wie angegeben, verschiedene Kupplungsmittel in unterschiedlicher Menge zugesetzt.

Für die Tabelle gelten die folgenden Erläuterungen:

Der Anteil an Kupplungsmittel ist jeweils auf den Gehalt an Diazoniumverbindung bezogen. Der pH-Wert gilt für den zum Entwickeln der Platte verwendeten Entwickler. Die Werte für die voll gedeckten bzw. teilweise gedeckten Stufen bezeichnen jeweils die letzte vollgedeckte Stufe bzw. die letzte teilgedeckte Stufe auf einem 21-stufigen Staufferkeil nach dem Entwickeln. Der Freilaufwert gibt jeweils die Zahl der Drucke an, die durchlaufen müssen, bis ein brauchbarer Druck erhalten wird. Der Wert für die Lagerfähigkeit wird durch Lagern der Platten bei 100° C ermittelt.

| | |
|---|---|
| 0 | = wie Vergleichsprobe oder ähnlich wie Vergleichsprobe |
| + | = besser als Vergleichsprobe bei gleichem Beschichtungsgewicht |
| + + | = wesentlich besser als Vergleichsprobe bei gleichem Beschichtungsgewicht |
| V1 | = Vergleichsbeispiel 1 |
| V2 | = Vergleichsbeispiel 2 |
| V3 | = Vergleichsbeispiel 3 |
| B | = Beispiel |

Tabelle

| Beispiel | Kupplungsmittel | Konzentration (%) | Beschichtungsgewicht mg/m² | Belichtungseinheiten | Kontrast nach Belichtung | pH-Wert Entwicklung | Stufen gedeckt | Stufen teilgedeckt | Freilaufwert | Lagerfähigkeit |
|---|---|---|---|---|---|---|---|---|---|---|
| V 1 | - | - | 800 | 35 | 0 | 11 schwierig | 6 | 13 | 300 | 0 |
| V 2 | - | - | 800 | 35 | 0 | 8 schwierig | 5 | 13 | 300 | 0 |
| V 3 | - | - | 400 | 25 | 0 | 11 leicht | 5 | 12 | 300 | 0 |
| B 2 | 2,4-Resorcylsäure-ethanolamid | 25 | 800 | 35 | ++ | 11 sehr leicht | 8 | 13 | 20 | ++ |
| B 3 | 2,4-Resorcylsäure-ethanolamid | 20 | 800 | 35 | ++ | 11 sehr leicht | 9 | 13 | 20 | ++ |
| B 4 | 2,4-Resorcylsäure-ethanolamid | 10 | 800 | 35 | + | 11 leicht | 9 | 13 | 50 | + |
| B 5 | 2,4-Resorcylsäure-ethanolamid | 5 | 800 | 35 | + | 11 schwierig | 7 | 12 | 100 | 0 |
| B 6 | 2,4-Resorcylsäure-ethanolamid | 20 | 400 | 25 | ++ | 11 sehr leicht | 8 | 11 | 30 | ++ |
| B 7 | 2,4-Resorcylsäure-ethanolamid | 20 | 400 | 25 | ++ | 8 sehr leicht | 7 | 10 | 40 | ++ |
| B 8 | 2,3-Hydroxy-1-naphthoesäure-ethanolamid | 20 | 800 | 35 | ++ | 11 sehr leicht | 7 | 12 | 20 | 0 |
| B 9 | 2,4-Resorcylsäure-amid | 20 | 800 | 35 | ++ | 11 sehr leicht | 9 | 13 | 40 | ++ |

Tabelle (Fortsetzung)

| Beispiel | Kupplungsmittel | Konzentration (%) | Beschichtungsgewicht mg/m² | Belichtungseinheiten | Kontrast nach Belichtung | pH-Wert Entwicklung | Stufen gedeckt | Stufen teilgedeckt | Freilaufwert | Lagerfähigkeit |
|---|---|---|---|---|---|---|---|---|---|---|
| B 10 | 4-Brom-3,5-Resorcylsäure | 30 | 800 | 35 | ++ | 11 sehr leicht | 6 | 9 | - | ++ |
| B 11 | 4-Brom-3,5-Resorcylsäure | 20 | 800 | 35 | ++ | 11 sehr leicht | 8 | 12 | 30 | ++ |
| B 12 | 4-Brom-3,5-Resorcylsäure | 10 | 800 | 35 | + | 11 leicht | 8 | 12 | 30 | ++ |
| B 13 | 4-Brom-3,5-Resorcylsäure | 5 | 800 | 35 | + | 11 leicht | 7 | 12 | 110 | + |
| B 14 | 4-Brom-3,5-Resorcylsäure | 2 | 800 | 35 | 0 | 11 schwierig | 6 | 13 | 300 | 0 |
| B 15 | 4-Brom-3,5-Resorcylsäure | 20 | 400 | 25 | ++ | 11 sehr leicht | 9 | 12 | 20 | ++ |
| B 16 | 4-Brom-3,5-Resorcylsäure | 10 | 400 | 25 | ++ | 11 sehr leicht | 8 | 11 | 30 | ++ |
| B 17 | 4-Brom-3,5-Resorcylsäure | 20 | 800 | 35 | ++ | 11 sehr leicht | 8 | 13 | 60 | ++ |
| B 18 | 2,6-Resorcylsäure | 20 | 800 | 35 | ++ | 11 sehr leicht | 3 | 12 | 50 | 0 |
| B 19 | 2-Hydroxy-3-naphthoesäure | 20 | 800 | 35 | ++ | 11 sehr leicht | 7 | 13 | 40 | + |

## Beispiel 20

Ein gemäß Vergleichsbeispiel 1 vorbehandelter Aluminiumträger wird mit einer Lösung der folgenden Zusammensetzung beschichtet:

1,82 % des Reaktionsproduktes aus Polyvinylbutyral (71 Gew.-% Vinylbutyral-, 2 Gew.-% Vinylacetat- und 27 Gew.-% Vinylalkohol-Einheiten; Molgewicht 70.000 bis 80.000) und Propenylsulfonylisocyanat,
1,8 % des im Vergleichsbeispiel 1 angegebenen Diazoniumsalz-Kondensationsproduktes,
0,02 % Phenylazodiphenylamin,
0,07 % $H_3PO_4$ (85 %ig),
0,09 % Viktoriareinblau FGA,
0,2 % 2,3-Dihydroxy-1-naphthoesäure-ethanolamid,
60,0 % Ethylenglykolmonomethylether,
30,0 % Tetrahydrofuran,
6,0 % Butylacetat,

so daß sich ein Beschichtungsgewicht von 1 g/m² ergibt.

Die Platte wird mit 35 Belichtungseinheiten belichtet und mit einer Lösung aus

5,0 % Natriumlaurylsulfat,
1,0 % Natriummetasilikat-pentahydrat in
94,0 % Wasser

entwickelt. Sie zeigt eine voll gedeckte Stufe 8 und eine teilweise gedeckte Stufe 13. Die gleiche Beschichtungsrezeptur ohne das Kupplungsmittel ergibt nur 7 voll gedeckte Stufen. Bei beiden Platten liegt die Auflagenhöhe im gleichen Bereich (150.000).

Beispiel 21

Ein durch Bürsten in einer Schleifmittelsuspension aufgerauhter, anodisch oxydierter und mit Polyvinylphosphonsäure nachbehandelter Aluminiumträger wird mit einer Lösung der folgenden Zusammensetzung beschichtet:

1,25 % eines Mischpolymerisats aus Styrol und Maleinsäurehalbester (Säurezahl 200, mittleres Molekulargewicht ca. 20 000),
2,5 % der Diazoniumverbindung aus Vergleichsbeispiel 1,
0,01 % Phenylazodiphenylamin,
0,25 % $H_3PO_4$ (85 %ig),
0,2 % Rhodamin 6 GDN (C.I. 45 160),
0,6 % 2,6-Resorcylsäure,
95,19 % Ethylenglykolmonomethylether,

so daß sich ein Beschichtungsgewicht von 1 g/m² ergibt.

Nach dem Belichten mit 30 Belichtungseinheiten und Entwickeln mit dem in Vergleichsbeispiel 1 beschriebenen Entwickler (pH-Wert 11) zeigt die Platte eine voll gedeckte Stufe 6 und teilweise gedeckte Stufen bis zur Stufe 11. Eine Vergleichsprobe ohne Kupplungsmittel ergibt unter den gleichen Verarbeitungsbedingungen nur eine voll gedeckte Stufe 5.

Beispiel 22

Ein Träger entsprechend Vergleichsbeispiel 1 wird mit einer Lösung der folgenden Zusammensetzung zu einem Beschichtungsgewicht von 800 mg/m² beschichtet:

3,0 % der Diazoniumverbindung aus Vergleichsbeispiel 1,
0,1 % $H_3PO_4$ (85 %ig),
0,9 % 4-Brom-3,5-resorcylsäure,
96,0 % Ethylenglykolmonomethylether.

Diese Platte wird durch eine Strichvorlage mit einer Belichtungseinheit belichtet. Nach dem Entwickeln mit dem Entwickler (pH-Wert 11) aus Vergleichsbeispiel 1 entsteht ein rotbraunes Bild von guter mechanischer und chemischer Beständigkeit. Die Bildstellen werden durch die Kupplungsreaktion in den nicht vollständig belichteten Bereichen gebildet. In diesen Bereichen ist die Löslichkeit im Entwickler so weit herabgesetzt, daß die zu einem unlöslichen Produkt führende Reaktion des unzersetzten Diazoniumsalzes mit dem Kupplungsmittel vorherrscht. Wenn eine derartige Reaktion bei der Erzeugung eines Bildes stattfindet, können hohe Lichtempfindlichkeiten erzielt werden. Eine Vergleichsbeschichtung ohne Kupplungsmittel wird durch den Entwickler vollständig entfernt.

Beispiel 23

Eine Lösung aus 3 % eines Diazoniumsalz-Polykondensationsprodukts, hergestellt aus Paraformaldehyd und Diphenylamin4-diazoniumchlorid in 85 %iger Phosphorsäure und 0,6 % 4-Brom-3,5-Resorcylsäure wird auf einen naß gebürsteten und anodisch oxydierten Träger aufgerieben.

Die Platte wird so belichtet, daß nach dem Entwickeln mit dem Entwickler aus Vergleichsbeispiel 1 die Stufe 6 voll gedeckt ist. Bei gleicher Belichtungszeit zeigt eine Vergleichsplatte ohne Kupplungsmittel nur eine voll gedeckte Stufe 4. Ähnliche Auswirkungen auf die Lichtempfindlichkeit werden auch festgestellt, wenn man einen wäßrigen Entwickler mit dem pH-Wert 8 oder den Jet-Black-Entwickler der Firma Western Litho verwendet.

## Patentansprüche

1. Verfahren zur Herstellung von Druckplatten durch Belichten eines lichtempfindlichen Materials, bestehend aus einem metallischen Schichtträger und einer sauren lichthärtbaren Schicht, die ein Diazoniumsalz-Polykondensationsprodukt und eine phenolische Verbindung der allgemeinen Formel I

   $[Ar(OH)_m(Z)_o(COX)_n]_pY$ (I)

   enthält, worin

   | | |
   |---|---|
   | Ar | ein ein- oder zweikerniger aromatischer Rest, |
   | Z | ein Halogenatom oder eine niedere Alkylgruppe, |
   | X | ein Halogenatom, eine Hydroxygruppe oder der Rest $NR^1R^2$, |
   | Y | eine Einfachbindung oder ein Bindeglied der Formel -O-, -S-, -CO-, $-C_dH_{2d}-$ ist, |
   | $R^1$ und $R^2$ | gleich oder verschieden sind und Wasserstoffatome, niedere Alkylgruppen oder Hydroxyalkylgruppen bedeuten, |
   | m | eine ganze Zahl von 1 bis 3, |
   | n | 1 oder 2, |
   | o | 0 oder 1, |
   | p | 1 oder 2 und d eine ganze Zahl von 1 bis 8 ist, |

   und Behandeln der belichteten Schicht mit einer Entwicklerlösung, dadurch gekennzeichnet, daß man die unbelichteten Schichtbereiche mit einer neutralen oder alkalischen Entwicklerlösung auswäscht.

2. Verfahren nach Anspruch 1, dadurch gekennzeichnet, daß die Entwicklerlösung gepuffert ist.

3. Verfahren nach Anspruch 1, dadurch gekennzeichnet, daß die Entwicklerlösung ein pH von 7,5 bis 12 hat.

4. Verfahren nach Anspruch 1, dadurch gekennzeichnet, daß das lichtempfindliche Material die phenolische Verbindung in einer Menge von 5 bis 40 Gew.-%, bezogen auf die Menge des Diazoniumsalz-Polykondensationsprodukts, enthält.

5. Verfahren nach Anspruch 1, dadurch gekennzeichnet, daß das lichtempfindliche Material in der lichthärtbaren Schicht zusätzlich ein polymeres Bindemittel enthält.

6. Verfahren nach Anspruch 1, dadurch gekennzeichnet, daß der Schichtträger aus Aluminium besteht.

## Claims

1. Process for the manufacture of printing plates by exposing a photosensitive material comprising a metallic coating base and an acidic photocurable coating which contains a diazonium salt polycondensation product and a phenolic compound of the formula I

   $[Ar(OH)_m(Z)_o(COX)_n]_pY$ (I)

   in which

   | | |
   |---|---|
   | Ar | is a mononuclear or binuclear aromatic radical, |
   | Z | is a halogen atom or a lower alkyl group, |
   | X | is a halogen atom, a hydroxyl group or the radical $NR^1R^2$, |
   | Y | is a single bond or a connecting member of the formula -O- , -S-, -CO-, $-C_dH_{2d}-$, |

- $R^1$ and $R^2$ are identical or different and are hydrogen atoms, lower alkyl groups or hydroxyalkyl groups,
- m is an integer from 1 to 3,
- n is 1 or 2,
- o is 0 or 1,
- p is 1 or 2, and
- d is an integer from 1 to 8,

and treating the exposed coating with a developer solution, characterised in that the unexposed coating regions are washed out with a neutral or alkaline developer solution.

**2.** Process according to Claim 1, characterised in that the developer solution is buffered.

**3.** Process according to Claim 1, characterised in that the developer solution has a pH of 7.5 to 12.

**4.** Process according to Claim 1, characterised in that the photosensitive material contains the phenolic compound in an amount of 5 to 40% by weight based on the amount of diazonium salt polycondensation product.

**5.** Process according to Claim 1, characterised in that the photosensitive material in the photocurable coating additionally contains a polymeric binder.

**6.** Process according to Claim 1, characterised in that the coating base is composed of aluminium.

## Revendications

**1.** Procédé pour la fabrication de plaques d'impression par exposition d'un matériau photosensible constitué d'un support métallique de couche et d'une couche photodurcissable acide qui contient un produit de polycondensation de sel de diazonium et un composé phénolique de formule générale I

$$[Ar(OH)_m(Z)_o(COX)_n]_pY \quad (I)$$

dans laquelle

- Ar représente un radical aromatique mono- ou bicyclique,
- Z représente un atome d'halogène ou un groupe alkyle inférieur,
- X représente un atome d'halogène, le groupe hydroxy ou un radical $NR^1R^2$,
- Y représente une simple liaison ou un chaînon de liaison de formule -O-, -S-, -CO-, $C_dH_{2d}$-, et
- $R^1$ et $R^2$ sont identiques ou différents et représentent des atomes d'hydrogène, des groupes alkyle inférieur ou des groupes hydroxyalkyle,
- m est un nombre entier allant de 1 à 3,
- n est 1 ou 2,
- o est 0 ou 1,
- p est 1 ou 2 et
- d est un nombre entier allant de 1 à 8,

et traitement de la couche exposée par une solution de développement, caractérisé en ce que l'on élimine les zones non exposées de la couche par lavage avec une solution de développement neutre ou alcaline.

**2.** Procédé selon la revendication 1, caractérisé en ce que la solution de développement est tamponnée.

**3.** Procédé selon la revendication 1, caractérisé en ce que la solution de développement a un pH de 7,5 à 12.

**4.** Procédé selon la revendication 1, caractérisé en ce que le matériau photosensible contient le composé phénolique en une quantité de 5 à 40 % en poids, par rapport à la quantité du produit de polycondensation de sel de diazonium.

**5.** Procédé selon la revendication 1, caractérisé en ce que le matériau photosensible contient en outre un liant polymère dans la couche photodurcissable.

6. Procédé selon la revendication 1, caractérisé en ce que le support de couche est constitué d'aluminium.